Europäisches Patentamt

European Patent Office

Office européen des brevets

(19)

(11) Publication number: **0 254 568 B1**

(12) **EUROPEAN PATENT SPECIFICATION**

(45) Date of publication of patent specification: **13.10.93**

(21) Application number: **87306520.5**

(22) Date of filing: **23.07.87**

(51) Int. Cl.⁵: **H01S 3/06**, H01S 3/103,
H01S 3/19, H01S 3/23

(54) **A semiconductor laser device.**

(30) Priorite: **25.07.86 JP 175965/86**
**25.07.86 JP 175966/86**
**25.07.86 JP 175967/86**
**25.07.86 JP 175968/86**
**25.07.86 JP 175969/86**
**25.07.86 JP 175970/86**
**25.07.86 JP 175971/86**
**25.07.86 JP 175972/86**
**25.07.86 JP 175973/86**
**25.07.86 JP 175974/86**
**25.07.86 JP 175975/86**
**26.07.86 JP 176287/86**

(43) Date of publication of application:
**27.01.88 Bulletin 88/04**

(45) Publication of the grant of the patent:
**13.10.93 Bulletin 93/41**

(84) Designated Contracting States:
**DE FR GB**

(73) Proprietor: **MITSUBISHI DENKI KABUSHIKI
KAISHA**
**2-3, Marunouchi 2-chome**
**Chiyoda-ku**
**Tokyo 100(JP)**

(72) Inventor: **Tokuda, Yasunori c/o Mitsubishi De-
nki K.K.**
**Chuo Kenkyusho**
**1-1, Tsukaguchi Honmachi 8-chome**
**Amagasaki-shi Hyogo-ken(JP)**
Inventor: **Fujiwara, Kenzo c/o Mitsubishi De-
nki K.K.**
**Chuo Kenkyusho**
**1-1, Tsukaguchi Honmachi 8-chome**
**Amagasaki-shi Hyogo-ken(JP)**
Inventor: **Tsukada, Noriaki c/o Mitsubishi De-
nki K.K.**
**Chuo Kenkyusho**
**1-1, Tsukaguchi Honmachi 8-chome**
**Amagasaki-shi Hyogo-ken(JP)**

(56) References cited:
**EP-A- 0 187 716**
**EP-A- 0 194 335**
**WO-A-85/00472**
**GB-A- 2 077 484**
**GB-A- 2 114 804**

**APPLIED PHYSICS LETTERS, vol. 47, no. 8, 15th October 1985, pages 781-783, American Institute of Physics, Woodbury, New York, US; E.O. GÖBEL et al.: "Homogeneous gain saturation in GaAs/AlGaAs quantum well lasers"**

**APPLIED PHYSICS LETTERS, vol. 45, no. 1, 1st July 1984, pages 1-3, American Institute of Physics, Woodbury, New York, US; T. FUKUZAWA et al.: "GaAlAs buried multiquantum well lasers fabricated by diffusion-induced disordering"**

**APPLIED PHYSICS LETTERS, vol. 48, no. 1, 6th January 1986, pages 7-9, American Institute of Physics, Woodbury, New York, US; R.L. THORNTON et al.: "Highly efficient multiple emitter index guided array lasers fabricated by silicon impurity induced disordering"**

**PATENT ABSTRACTS OF JAPAN, vol. 9, no. 288 (E-358)[2011], 15th November 1985; & JP-A-60 128 690**

**PATENT ABSTRACTS OF JAPAN, vol. 8, no. 226 (E-272)[1663], 17th October 1984; & JP-A-59 106 171**

**PATENT ABSTRACTS OF JAPAN, vol. 9, no. 131 (E-319)[1854], 6th June 1985; & JP-A-60 16 484**

**APPLIED PHYSICS LETTERS, vol. 49, no. 24, 15th December 1986, pages 1629-1631, American Institute of Physics, Woodbury, New York, US; Y. TOKUDA et al.: "Widely separate wavelength switching of single quantum well laser diode by injection-current control"**

Inventor: **Kojima, Keisuke c/o Mitsubishi Denki K.K.**
**Chuo Kenkyusho**
**1-1, Tsukaguchi Honmachi 8-chome**
**Amagasaki-shi Hyogo-ken(JP)**
Inventor: **Nomura, Yoshinori c/o Mitsubishi Denki K.K.**
**Chuo Kenkyusho**
**1-1, Tsukaguchi Honmachi 8-chome**
**Amagasaki-shi Hyogo-ken(JP)**
Inventor: **Matsui, Teruhito c/o Mitsubishi Denki K.K.**
**Chuo Kenkyusho**
**1-1, Tsukaguchi Honmachi 8-chome**
**Amagasaki-shi Hyogo-ken(JP)**

(74) Representative: **Beresford, Keith Denis Lewis et al**
**BERESFORD & Co.**
**2-5 Warwick Court**
**High Holborn**
**London WC1R 5DJ (GB)**

## Description

The present invention relates to a quantum well type semiconductor laser device, and more particularly to one which is capable of oscillating at a higher quantum level than the lowest quantum level.

In a semiconductor laser it is quite important in many practical applications to make the laser oscillate at as short a wavelength as possible.

Furthermore, a laser device which can emit light at each of a plurality of different wavelengths is useful in optical communication.

A semiconductor laser in which the active layer of the usual double heterostructure laser is replaced by a quantum well structure or a superlattice structure is called a quantum well type semiconductor laser. A laser which includes a potential well layer in the active layer is called a single quantum well laser, and a laser which includes a plurality of potential well layers in the active layer is called a multi-quantum well laser.

The operation of the semiconductor laser element having a quantum well structure active layer will be described below.

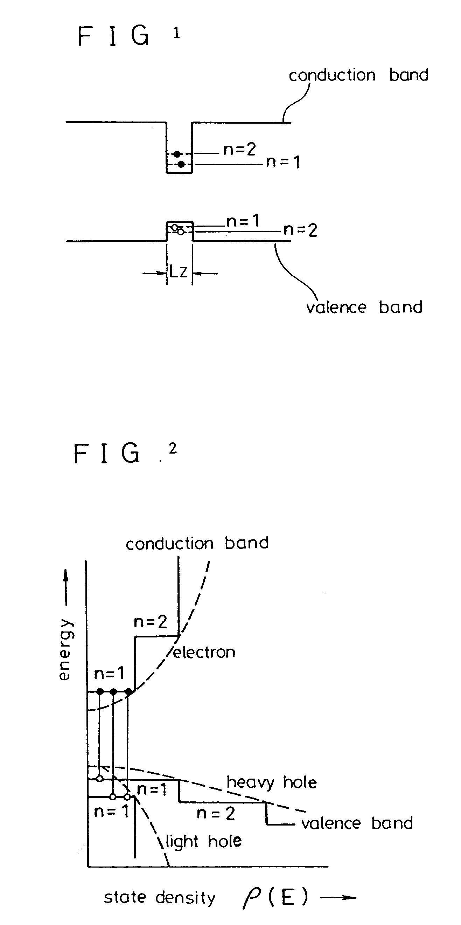

Figure 1 is a diagram showing the energy levels of a quantum well structure. The longitudinal axis designates energy, and the transverse axis designates position perpendicular to the layers. As shown in Figure 1 when a quantum well is constituted by putting a thin semiconductor layer between semiconductor barrier layers having a large energy band gap, then this thin semiconductor layer constitutes a potential well layer, and the intrinsic energy En measured from the bottom (top) of the conduction (valence) band of the electrons (holes) confined in this well is represented by the following Schrodinger equation (1), and forms discrete energy levels.

$$E_n = \frac{\hbar^2}{2 m_e^{*}} \left( \frac{\pi n}{L_z} \right)^2 \qquad n = 1, 2, 3 \qquad \ldots (1)$$

Herein, $m_e^{*}$ is an effective mass of electron, $\hbar$ is a Planck's constant divided by $2\pi$, and Lz is thickness of the quantum well layer. Herein, the thickness and height of the barrier layer are presumed to be infinity so as to enable one dimensional treating.

In this way an electron has quantized energies En, and the electron state density $\rho$ (E) becomes a step like distribution as shown in figure 2. The electron state density usually has a parabola type distribution, also as shown.

Accordingly, when both of the layers respectively above and below the active quantum well layer are made a p type semiconductor cladding layer and an n type semiconductor cladding layer each having large energy band gaps, it is possible both to confine the carriers (electrons or holes) and to confine the light in the thickness direction, so that as a result a quantum well type semiconductor laser is produced. A semiconductor laser constructed in this manner has an n = 1 level (the lowest quantum level) higher than the bottom of the conduction band. When the active layer is produced of material which has the same energy band gap as that of material constituting the active layer of the usual double heterostructure semiconductor laser, it oscillates at a shorter wavelength because the energy difference is larger than that of a usual double heterostructure semiconductor laser which oscillates by the energy difference between the bottom of the conduction band and the top of the valence band. Furthermore, the quantum well type semiconductor laser has characteristics that the energy levels are discrete and characteristics having a narrow spectrum line width and a good monochromaticity.

An example of a quantum well type semiconductor laser is described in European Patent Application EP-A-0194335. The laser device, which is described with reference to figure 3 thereof, comprises a substrate layer of n-type GaAs, a GaAs buffer layer of thickness 0.1 to 0.5 $\mu$m, a lower cladding layer of $Ga_{1-x} Al_x$ As : x = 0.4 and thickness 1 $\mu$m, a quantum well active layer structure comprising three sub layers, one of $Ga_{1-z}Al_zAs$ : 0.1<z<0 and thickness less than 20 nm sandwiched between two sub-layers of $Ga_{1-y}Al_yAs$ : y = 0.2 each of thickness 10 nm, an upper cladding layer of $Ga_{1-x}Al_xAs$ : x - 0.4 and thickness 1 nm, and a contact layer of dopant enriched p-type GaAs layer of thickness 0.1 to 0.5 $\mu$m.

A common electrode is provided on the lower surface of the substrate and a contact structure is provided on the upper undivided surface of the contact layer. This contact structure comprises two spaced apart strip like electrodes which are arranged co-linearly and are of different respective lengths. The longer one of these stripes corresponds to the laser active region, while the shorter one corresponds to a loss control region. Laser loss is controlled by varying the current injected into the laser by means of this shorter stripe. A multi-quantum well active layer structure can be substituted for the active layer described.

The present invention also provides a quantum well type semiconductor laser and is an alternative to that just described.

In accordance with a first aspect of the present invention there is provided a method of operating a current injection semiconductor laser, which laser includes an active layer of a quantum well structure, at least one current electrode by which means current can be injected into said active layer, and a voltage electrode by which means a reverse bias voltage may be applied and an electric field developed across a portion (B) of said laser,

which method comprises:

injecting current into said active layer to cause said laser to emit radiation at a first resonant wavelength corresponding to a quantized level transition in said active layer; and

applying a reverse bias voltage to said voltage electrode to cause a shift in the exciton absorption spectrum of said portion (B) of said laser so that whilst current is injected into said active layer said laser is caused to emit radiation at a second resonant wavelength corresponding to a quantized level transition different from said first resonant wavelength.

In accordance with a second aspect of the present invention there is provided a current injection semiconductor laser system for performing the method of claim 1, which system comprises:

a current injection semiconductor laser having an active layer of a quantum well structure, at least one current electrode by which means current can be injected into said active layer, and a voltage electrode by which means a reverse bias voltage may be applied and an electric field developed across a portion (B) of said laser;

a current source connected to said at least one current electrode for injecting current into said active layer of the laser to stimulate emission individually at each one of a first resonant wavelength corresponding to a quantized level transition and a second resonant wavelength corresponding to another quantized level transition respectively; and

a voltage source connected to said voltage electrode for supplying a reverse bias voltage which shall cause a shift in the exciton absorption spectrum of said portion (B) of said laser sufficient that resonance at said first resonant wavelength shall be suppressed in favour of resonance at said second resonant wavelength.

In accordance with a third aspect of the present invention there is provided a current injection semiconductor laser said laser comprising:

a quantum well active layer;

adjacent cladding layers of opposite conductivity type, respectively below and above said active layer;

an electrode structure overlying said active layer, which electrode structure is comprised of at least two spaced electrodes, namely a current electrode and a voltage electrode; and

an electrical contact layer located between said electrode structure and one of said cladding layers, this electrical contact layer being subdivided and separated by means of insulation to isolate said current electrode and said voltage electrode, wherein

that portion (B) of said laser underlying said voltage electrode exhibits an exciton absorption spectrum which is capable of a shift, in the presence of a reverse bias voltage applied to said voltage electrode, that is sufficient to cause said laser to change resonant wavelength.

In the accompanying drawings:

Figure 1 is a diagram showing a typical energy band gap structure of a quantum well active layer;

Figure 2 is a diagram showing the state density and energy levels of this quantum well;

Figure 3 is a diagram showing the structure of a semiconductor laser, an embodiment of the present invention;

Figure 4 is a diagram for exemplifying the operation of this embodiment; and

Figure 5 is a diagram showing an alternative embodiment;

So that this invention shall be better followed, preferred embodiments thereof will be described now in particular detail and reference will be made to the accompanying drawing just listed.

The description that follows is intended by way of example only.

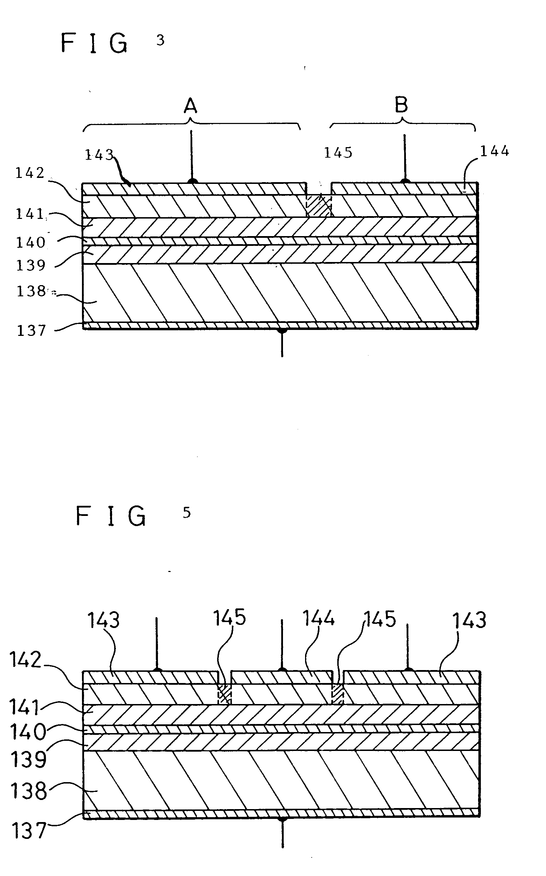

Figure 3 shows a first embodiment of the present invention. In Figure 3, the reference numeral 137 designates a lower electrode, the reference numeral 138 designates an n type GaAs substrate, the reference numeral 139 designates a lower n type AlGaAs cladding layer, the reference numeral 140 designates a GaAs quantum well active layer, the reference numeral 141 designates an upper p type AlGaAs cladding layer, the reference numeral 142 designates a p type GaAs contact layer, the reference numeral 143 designates an electrode for current injection, the reference numeral 144 designates an electrode for loss modulation, and the reference numeral 145 designates an insulating region for electrically separating the current injection portions A and B.

The device will be operated as follows.

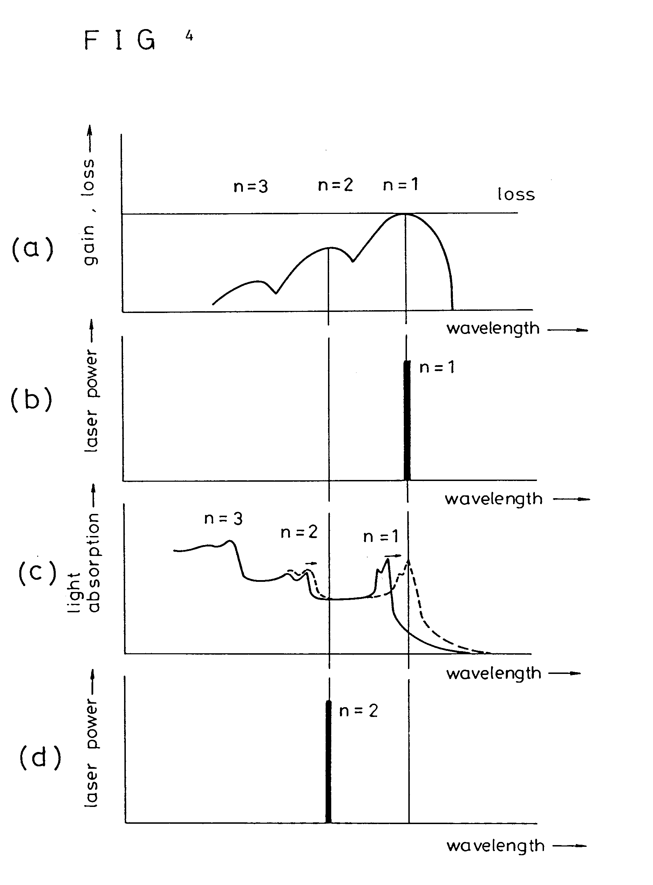

Figure 4 shows a gain spectrum of this first embodiment. n = 1, 2, 3, ... designate the gain peaks corresponding to the transitions at the first, second, and third quantum levels of the electrons and holes, respectively. Figure 4 shows a case where an oscillation of transition corresponding to n = 1 is occured due to that the gain of n = 1 is balanced with the resonator loss. Figure 4 shows an oscillation spectrum in this case.

Furthermore, it is known that the exciton peak of the absorption spectrum (n = 1, 2, 3, ...) is shifted by 20 to 30 meV to the high energy side with relative to the respective laser oscillation wavelength.

Next, a reverse bias is applied to the loss modulation portion so as to shift the exciton peak to the oscillation wavelength of n = 1 as shown in Figure 4 (the real lines show the absorption spectrum when the applied voltage is 0, and the broken lines show an absorption spectrum when the reverse bias voltage application is conducted).

By this, a resonator internal loss is induced against the laser oscillation wavelength corresponding to n = 1, and this laser oscillation is supressed. As a result, the consumption of population caused by the induced emission from the quantum level n = 1 is gone, and the carriers become to occupy the quantum level of n = 2. As shown in Figure 4 the shift of the exciton peak corresponding to n = 2 is small, and the resonator internal loss due to the reverse bias voltage application has almost no effect on the corresponding laser oscillation. Accordingly, a laser oscillation corresponding to this transition arises. Figure 4 shows an oscillation spectrum of this case. In this way, when the reverse bias is not applied a laser oscillation corresponding to the quantum level n = 1 is conducted, and when the reverse bias is applied a laser oscillation corresponding to the quantum level n = 2 is conducted.

As described above, in this embodiment an electrode for applying a reverse bias to the same layer structure as that to which a gain current is injected is provided in a semiconductor laser having a quantum well structure, whereby the internal loss is selectively enhanced in accordance with the oscillation wavelength by the control of the voltage applied from this electrode, whereby an oscillation at a high quantum level is enabled, and switching of the oscillation wavelengths is possible by this control.

In the above-described first embodiment the loss modulation portion B is provided at one side of laser end surfaces, but this may be provided at the central portion of the laser as in the alternative embodiment shown in Figure 5.

Furthermore, the active layer may be of a multiple quantum well structure, having a plurality of quantum well layers, instead of a single well structure. Furthermore, the present invention may be applied to a semiconductor laser of a ridge waveguide type, a BH (Buried Heterostructure) type, a CSP (Channeled Substrate Planer) type, or a superlattice disordered type.

Furthermore in the above-illustrated embodiments, the laser oscillations of n = 1 and n = 2 are described, but the present invention may be applied to one conducting a laser oscillation corresponding to a further higher quantum level.

The layer thickness of the quantum well active layer and the stripe width of the light waveguide of the semiconductor laser have not been described yet in detail. However, the layer thickness typically may be less than 30 nm Also the stripe width may be less than 10 nm to increase the loss of the light transmission and to enhance the occupation proportion of the higher quantum levels by making it difficult for the injected carriers to be subjected to energy relaxation.

Furthermore, as a method of producing such a narrow stripe a method recited in the Journal of Applied Physics vol.58, p.4515 (1985) can be used in order to accomplish a lowering of the threshold value. However, the method of producing the narrow stripe is not limited to that method, and any method capable of obtaining a narrow stripe width active layer can be used. That is, as the transverse direction confinement, a ridge waveguide, a buried heterostructure, a channeled substrate, or a general superlattice disordering by impurity diffusion can be used.

In the illustrated embodiment a laser using GaAs/AlGaAs is described, but InP/InGaAsP can be also used with the same effects as described above.

As is evident from the foregoing description, the resonator internal loss is enhanced to some degree thereby to control the balance between the gain and the loss, whereby laser oscillation at a higher quantum level is favoured. This enables conducting an oscillation at a short wavelength, and switching the oscillation wavelength by a switching of bias voltage. An integrated semiconductor laser for wavelength multiple light communication oscillating at different wavelengths is easily obtained at a low cost, and the utilization efficiency thereof is quite significant.

**Claims**

1. A method of operating a current injection semiconductor laser, which laser includes an active layer of a quantum well structure (140), at least one current electrode (143) by which means current can be injected into said active layer (140), and a voltage electrode (144) by which means a reverse bias voltage may be applied and an electric field developed across a portion (B) of said laser,

which method comprises:

injecting current into said active layer (140) to cause said laser to emit radiation at a first resonant wavelength corresponding to a quantized level transition in said active layer; and

applying a reverse bias voltage to said voltage electrode to cause a shift in the exciton absorption spectrum of said portion (B) of said laser so that whilst current is injected into said active layer (140) said laser is caused to emit radiation at a second resonant wavelength corresponding to a quantized level transition different from said first resonant wavelength.

2. A current injection semiconductor laser system for performing the method of claim 1, which system comprises:

a current injection semiconductor laser having an active layer (140) of a quantum well structure, at least one current electrode (143) by which means current can be injected into said active layer (140), and a voltage electrode (144) by which means a reverse bias voltage may be applied and an electric field developed across a portion (B) of said laser;

a current source connected to said at least one current electrode (143) for injecting current into said active layer (140) of the laser to stimulate emission individually at each one of a first resonant wavelength corresponding to a quantized level transition and a second resonant wavelength corresponding to another quantized level transition respectively; and

a voltage source connected to said voltage electrode for supplying a reverse bias voltage which shall cause a shift in the exciton absorption spectrum of said portion (B) of said laser sufficient that resonance at said first resonant wavelength shall be suppressed in favour of resonance at said second resonant wavelength.

3. A current injection semiconductor laser for use in the system of claim 2, said laser comprising:

a quantum well active layer (140);

adjacent cladding layers (139,141) of opposite conductivity type, respectively below and above said active layer (140);

an electrode structure (143,144) overlying said active layer (140), which electrode structure is comprised of at least two spaced electrodes, namely a current electrode (143) and a voltage electrode (144); and

an electrical contact layer (142) located between said electrode structure (143,144) and one (141) of said cladding layers (139,141), this electrical contact layer (142) being subdivided and separated by means of insulation (145) to isolate said current electrode (143) and said voltage electrode (144), wherein

that portion (B) of said laser underlying said voltage electrode (144) exhibits an exciton absorption spectrum which is capable of a shift, in the presence of a reverse bias voltage applied to said voltage electrode (144), that is sufficient to cause said laser to change resonant wavelength.

4. A laser as claimed in claim 3 wherein that portion (B) of said laser underlying said voltage electron (144) exhibits an exciton absorption spectrum having a peak absorption offset from a resonant wavelength of said laser, which peak can be shifted to said resonant wavelength by application of said reverse bias voltage.

5. A laser as claimed in either one of the preceding claims 3 or 4 wherein said change in resonant wavelength is a change between the $n = 1$ and $n = 2$ quantum state resonant wavelengths.

6. A laser as claimed in any of claims 3-5 wherein said electrode structure (143, 144) is comprised of a single current injection electrode (143) and a single voltage bias electrode (144).

7. A laser as claimed in any of claims 3-5 wherein said electrode structure (143, 144) is comprised of a pair of current injection electrodes (143, 143) and a single voltage bias electrode (144) located between said pair of electrodes (143, 143).

8. A laser as claimed in any of claims 3 to 7 wherein said active layer (140) is of a single quantum well structure.

9. A laser as claimed in any of claims 3 to 7 wherein said active layer (140) is of a multiple quantum well structure.

**Patentansprüche**

1. Verfahren zum Betreiben eines Strominjektions-Halbleiter-Lasers, der eine aktive Schicht mit einer Quantenmuldenstruktur (140), mindestens eine Stromelektrode (143), mit der Strom in die aktive Schicht (140) injiziert werden kann, und eine Spannungselektrode (144) enthält, mit der eine Sperr-Vorspannung angelegt werden kann und in einem Teil (B) des Lasers ein elektrisches Feld aufgebaut werden kann,

wobei bei dem Verfahren

Strom in die aktive Schicht (140) injiziert wird, um zu bewirken, daß der Laser Strahlung mit einer ersten Resonanzwellenlänge, die einem Übergang zwischen quantisierten Niveaus in der aktiven Schicht entspricht, aussendet; und

eine Sperr-Vorspannung an die Spannungselektrode angelegt wird, um eine Verschiebung des Exzitonen-Absorptionsspektrums im Teil (B) des Lasers zu verursachen, so daß bewirkt wird, daß der Laser, während Strom in die aktive Schicht (140) injiziert wird, Strahlung mit einer zweiten Resonanzwellenlänge, die einem Übergang zwischen quantisierten Niveaus entspricht und von der ersten Resonanzwellenlänge verschieden ist, aussendet.

2. Strominjektions-Halbleiter-Lasersystem zum Ausführen des Verfahrens nach Anspruch 1, mit:

einem Strominjektions-Halbleiter-Laser, der eine aktive Schicht (140) mit einer Quantenmuldenstruktur, mindestens eine Stromelektrode (143), mit der Strom in die aktive Schicht (140) injiziert werden kann, und eine Spannungselektrode (144) aufweist, mit der eine Sperr-Vorspannung angelegt werden kann und in einem Teil (B) des Lasers ein elektrisches Feld aufgebaut werden kann,

einer Stromquelle, die an die mindestens einfach vorhandene Stromelektrode (143) angeschlossen ist, zum Injizieren von Strom in die aktive Schicht (140) des Lasers, um jeweils bei einer ersten einem Übergang zwischen quantisierten Niveaus entsprechenden Resonanzwellenlänge und einer zweiten einem anderen Übergang zwischen quantisierten Niveaus entsprechenden Resonanzwellenlänge einzeln Emission zu stimulieren; und

einer Spannungsquelle, die an die Spannungselektrode angeschlossen ist, zum Anlegen einer Sperr-Vorspannung, die eine Verschiebung des Exzitonen-Absorptionsspektrums von dem Teil (B) des Lasers verursacht, welche zum Unterdrücken der Resonanz bei der ersten Resonanzwellenlänge zu Gunsten einer Resonanz bei der zweiten Resonanzwellenlänge ausreicht.

3. Strominjektions-Halbleiter-Laser zur Verwendung bei dem System nach Anspruch 2 mit:

einer aktiven Quantenmuldenschicht (140);

Überzugsschichten (139, 141) von entgegengesetztem Leitfähigkeitstyp, die jeweils unten und oben an die aktive Schicht (140) angrenzen;

einer Elektrodenanordnung (143, 144), die die aktive Schicht (140) überlagert, wobei die Elektrodenanordnung aus mindestens zwei beabstandeten Elektroden besteht, nämlich einer Stromelektrode (143) und einer Spannungselektrode (144); und

einer elektrischen Kontaktschicht (142), die sich zwischen der Elektrodenanordnung (143, 144) und einer (141) der Überzugsschichten (139, 141) befindet, wobei diese elektrische Kontaktschicht (142) durch eine Isoliervorrichtung (145) zum Isolieren der Stromelektrode (143) und der Spannungselektrode (144) unterteilt und getrennt ist, wobei

der unter der Spannungselektrode (144) liegende Teil (B) des Lasers ein Exzitonen-Absorptionsspektrum aufweist, das in Gegenwart einer an die Spannungselektrode (144) angelegten Sperr-Vorspannung in ausreichendem Maße verschiebbar ist, um eine Änderung der Resonanzwellenlänge des Lasers zu verursachen.

**4.** Laser nach Anspruch 3, wobei der unter der Spannungselektrode (144) liegende Teil (B) des Lasers ein Exzitonen-Absorptionsspektrum mit einem gegenüber einer Resonanzwellenlänge des Lasers versetzten Absorptionsmaximum aufweist, das durch Anlegen der Sperr-Vorspannung zu der Resonanzwellenlänge verschoben werden kann.

**5.** Laser nach einem der vorangehenden Ansprüche 3 oder 4, wobei die Änderung der Resonanzwellenlänge in einer Änderung zwischen den Resonanzwellenlängen zu den Quantenzuständen n = 1 und n = 2 besteht.

**6.** Laser nach einem der Ansprüche 3 bis 5, wobei die Elektrodenanordnung (143, 144) aus einer einzigen Strominjektionselektrode (143) und einer einzigen Vorspannelektrode (144) besteht.

**7.** Laser nach einem der Ansprüche 3 bis 5, wobei die Elektrodenanordnung (143, 144) aus einem Paar von Strominjektionselektroden (143, 143) und einer einzigen zwischen dem Elektrodenpaar (143, 143) befindlichen Vorspannelektrode (144) besteht.

**8.** Laser nach einem der Ansprüche 3 bis 7, wobei die aktive Schicht (140) aus einer Quantenmuldenstruktur mit einer einzigen Quantenmulde besteht.

**9.** Laser nach einem der Ansprüche 3 bis 7, wobei die aktive Schicht (140) aus einer Quantenmuldenstruktur mit mehreren Quantenmulden besteht.

## Revendications

**1.** Un procédé pour faire fonctionner un laser à semiconducteurs à injection de courant, ce laser comprenant une couche active ayant une structure de puits quantique (140), au moins une électrode de courant (143) au moyen de laquelle on peut injecter du courant dans la couche active (140), et une électrode de tension (144) au moyen de laquelle on peut appliquer une tension de polarisation inverse et on peut produire un champ électrique dans une partie (B) du laser,

ce procédé comprenant :

l'injection d'un courant dans la couche active (140) pour que le laser émette un rayonnement à une première longueur d'onde de résonance correspondant à une transition de niveaux quantifiés dans la couche active; et

l'application d'une tension de polarisation inverse à l'électrode de tension pour produire un décalage dans le spectre d'absorption d'excitons de la partie précitée (B) du laser, de façon que lorsqu'un courant est injecté dans la couche active (140), ce laser émette un rayonnement à une seconde longueur d'onde de résonance correspondant à une transition de niveaux quantifiés, qui est différente de la première longueur d'onde de résonance.

**2.** Un système de laser à semiconducteurs à injection de courant pour la mise en oeuvre du procédé de la revendication 1, ce système comprenant :

un laser à semiconducteurs à injection de courant ayant une couche active (140) qui a une structure de puits quantique, au moins une électrode de courant (143) au moyen de laquelle on peut injecter un courant dans la couche active (140), et une électrode de tension (144) au moyen de laquelle on peut appliquer une tension de polarisation inverse et on peut produire un champ électrique dans une partie (B) du laser;

une source de courant connectée à l'électrode de courant ou aux électrodes de courant (143), pour injecter un courant dans la couche active (140) du laser, de façon à stimuler une émission individuellement à chaque longueur d'onde respective parmi une première longueur d'onde de résonance correspondant à une transition de niveaux quantifiés, et une seconde longueur d'onde de résonance correspondant à une autre transition de niveaux quantifiés; et

une source de tension connectée à l'électrode de tension pour appliquer une tension de polarisation inverse qui provoque un décalage dans le spectre d'absorption d'excitons de la partie précitée (B) du laser, qui est suffisante pour que la résonance à la première longueur d'onde de résonance soit atténuée en faveur de la résonance à la seconde longueur d'onde de résonance.

**3.** Un laser à semiconducteurs à injection de courant prévu pour l'utilisation dans le système de la revendication 2, ce laser comprenant :

une couche active à puits quantique (140);

des couches de gaine adjacentes (139, 141) ayant des types de conductivité opposés, qui sont situées respectivement au-dessous et au-dessus de la couche active (140);

une structure d'électrodes (143, 144) recouvrant la couche active (140), cette structure d'électrodes comprenant au moins deux électrodes espacées, à savoir une électrode de courant (143) et une électrode de tension (144); et

une couche de contact électrique 142) qui est placée entre la structure d'électrodes (143, 144) et l'une (141) des couches de gaine (139, 141), cette couche de contact électrique (142) étant subdivisée et séparée au moyen d'une isolation (145), pour isoler l'électrode de courant (143) et l'électrode de tension (144), dans lequel

la partie (B) du laser qui se trouve au-dessous de l'électrode de tension (144) présente un spectre d'absorption d'excitons qui est capable de subir un décalage, en présence d'une tension de polarisation inverse appliquée à l'électrode de tension (144), qui est suffisant pour que le laser change de longueur d'onde de résonance.

4. Un laser selon la revendication 3, dans lequel la partie (B) du laser qui se trouve au-dessous de l'électrode de tension (144) présente un spectre d'absorption ayant un pic d'absorption qui est situé à distance d'une longueur d'onde de résonance du laser, et ce pic peut être décalé vers la longueur d'onde de résonance par l'application de la tension de polarisation inverse.

5. Un laser selon l'une quelconque des revendications 3 ou 4 précédentes, dans lequel le changement de longueur d'onde de résonance est un changement entre les longueurs d'onde de résonance qui correspondent aux états quantiques $n = 1$ et $n = 2$.

6. Un laser selon l'une quelconque des revendications 3 à 5, dans lequel la structure d'électrodes (143, 144) est constituée par une seule électrode d'injection de courant (143) et par une seule électrode de polarisation de tension (144).

7. Un laser selon l'une quelconque des revendications 3 à 5, dans lequel la structure d'électrodes (143, 144) comprend une paire d'électrodes d'injection de courant (143, 143) et une seule électrode de polarisation de tension (144) qui est placée entre la paire précitée d'électrodes (143, 143).

8. Un laser selon l'une quelconque des revendications 3 à 7, dans lequel la couche active (140) a une structure à puits quantique unique.

9. Un laser selon l'une quelconque des revendications 3 à 7, dans lequel la couche active (140) a une structure à puits quantiques multiples.

F I G 1

conduction band

n=2
n=1

n=1
n=2

Lz

valence band

F I G 2

conduction band

energy

n=2

electron

n=1

heavy hole

n=1

n=1
n=2

valence band

light hole

state density $\rho(E)$

10

FIG 3

FIG 5

F I G 4